# EUROPÄISCHE PATENTSCHRIFT

(11) **EP 2 979 311 B1**
(45) Veröffentlichungstag und Bekanntmachung des Hinweises auf die Patenterteilung: **20.02.2019**
(21) Anmeldenummer: 14713411.8
(22) Anmeldetag: 19.03.2014
(51) Int. Cl.: H01L 41/04

(54) **SCHALTUNGSANORDNUNG UND VERFAHREN ZUR ANSTEUERUNG EINES PIEZOTRANSFORMATORS**
CIRCUIT ASSEMBLY AND METHOD FOR CONTROLLING A PIEZOELECTRIC TRANSFORMER
AGENCEMENT DE CIRCUIT ET PROCÉDÉ D'EXCITATION D'UN TRANSFORMATEUR PIÉZOÉLECTRIQUE

(30) Priorität: 27.03.2013 DE 102013103159
(43) Veröffentlichungstag der Anmeldung: 03.02.2016
(73) Patentinhaber: TDK Electronics AG, 81671 München (DE)
(72) Erfinder: KRAXNER, Peter, 8072 Fernitz (AT); PUFF, Markus, 8010 Graz (AT)
(74) Vertreter: Epping - Hermann - Fischer
(86) Internationale Anmeldenummer: PCT/EP2014/055515
(87) Internationale Veröffentlichungsnummer: WO 2014/154548

(56) Entgegenhaltungen:
- EP-A1- 0 665 600
- EP-B1- 2 798 319
- WO-A2-2013/083678
- US-A- 3 657 579
- TAKAHASHI S ET AL: "Nonlinear piezoelectric response in ferroelectric ceramics driven at resonant mode", 11TH IEEE INTERNATIONAL SYMPOSIUM ON APPLICATIONS OF FERROELECTRICS, ISAF 1998, 24-27 AUGUST 1998, MONTREUX, SWITZERLAND, 1998, Seiten 381-384, XP010347236, DOI: 10.1109/ISAF.1998.786713 ISBN: 978-0-7803-4959-9

## Beschreibung

Die Erfindung betrifft eine Schaltungsanordnung und ein Verfahren zur Ansteuerung eines Piezotransformators.

Ein Piezotransformator, der auch als piezoelektrischer Transformator bezeichnet werden kann, ist ein elektromechanisches System, das als Resonanztransformator dient. Der Piezotransformator ermöglicht, eine zugeführte elektrische Wechselspannung in eine höhere oder niedrigere Wechselspannung umzusetzen. Die Umsetzung kann bei der Resonanzfrequenz des Piezotransformators erfolgen, welche von den mechanischen Abmessungen und dem Material des Piezotransformators bestimmt wird.

Ein Ansatz zur Regelung eines Piezotransformators sieht vor, Eingangsspannung, Eingangsstrom und deren Phasenlage als Regelinformationen zu verwenden. Anhand dieser Parameter können eine Ansteuerung des Piezotransformators und die Regelung seines Verhaltens erfolgen. Jedoch wird damit der optimale Arbeitspunkt des Piezotransformators nicht getroffen. Auftretende Verluste durch nicht abstimmbare Regeleinflüsse beeinträchtigen die Performance und Effizienz des Piezotransformators. Diese Blindleistung wird vom Versorger bereitgestellt und vom Piezotransformator nur auf der Primärseite umgesetzt.

Takahashi, S. et al. "Nonlinear piezoelectric response in ferroelectric ceramics driven at resonant mode", 11th IEEE International Symposium on Applications of Ferroelectrics, ISAF 1998, 24.-27. August 1998, Montreux, Seiten 381-384 betrifft die Messung piezoelektrischer Eigenschaften eines Resonators mittels eines Konstantstromregelkreises mit einem Resonator in einem eingangsseitigen Zweig eines Differenzverstärkers und einem Kondensator in einem weiteren eingangsseitigen Zweig des Differenzverstärkers.

EP 2 798 319 B1 (Art. 54(3) EPÜ Schrift) offenbart eine Messanordnung einer Prozessgröße eines Mediums in einem Behälter mit einer Schaltung umfassend zwei parallele RC-Zweige gleicher Zeitkonstante und einen Differenzverstärker, der zur Selbstanregung rückgekoppelt sein kann, wobei einer der Zweige einen Piezowandler, der als Sender und Empfänger mechanischer Schwingungen dient, mit einem Serienwiderstand aufweist und der andere Zweig einen Kompensationskondensator mit einem Serienwiderstand aufweist.

WO 2013/083678 A2, US 3,657,579 A und EP 0665600 A1 betreffen die Ansteuerung eines piezoelektrischen Transformators.

Ziel ist die Detektion einer geeigneten Stellgröße zur Regelung eines Piezotransformators, um einen optimierten Betrieb mit minimalen Verlusten bei den gewählten Einsatzbedingungen des Piezotransformators im ausgewählten Einsatzbereich beziehungsweise -gebiet sicherzustellen. Der Betrieb des Piezotransformators soll sowohl im Impulsbetrieb als auch im Dauerbetrieb im gewünschten Rahmen ermöglicht werden. Durch Nutzung geeigneter Feedbackparameter soll ein gleichbleibender Betriebszustand des Piezotransformators sichergestellt werden.

Zum Betrieb des Piezotransformators ist es erforderlich, diesen in allen Betriebszuständen (Start, Betrieb, Laständerung, geänderte Umweltbedingungen) mit seiner Betriebsfrequenz und der benötigten Arbeitsspannung und -strom in entsprechender Phasenlage zu versorgen, um die Funktion des Piezotransformators zu gewährleisten.

Die Aufgabe wird durch eine Schaltungsanordnung mit den Merkmalen des Anspruchs 1 gelöst. Die Schaltungsanordnung umfasst einen ersten Schaltungszweig aufweisend einen Piezotransformator, der eine Eingangskapazität hat, einen zweiten Schaltungszweig, der die Eingangskapazität kompensiert, und einen Differenzverstärker mit einem ersten Eingang, der gekoppelt ist mit dem ersten Schaltungszweig, und einem zweiten Eingang, der gekoppelt ist mit dem zweiten Schaltungszweig. Der erste und zweite Schaltungszweig sind parallel geschaltet.

Die Kopplung kann durch eine direkte Verbindung oder über weitere Komponenten erfolgen.

Diese Schaltungsanordnung bedient sich Regelgrößen, die zur Beschreibung des Piezotransformatorverhaltens phasen- und amplitudenrichtig vorliegen, und ermöglicht eine verlustarme Anregung der Schwingungen des Piezotransformators.

Die Eingangskapazität des Piezotransformators ist eine konstruktionsbedingte Kapazität zwischen den Piezotransformatorelektroden. Das Verhalten des Piezotransformators kann durch ein Ersatzschaltbild beschrieben werden. Das Ersatzschaltbild des Piezotransformators mit einem Reihenschwingkreis, umfassend ein kapazitives Element, ein induktives Element und einen Widerstand, berücksichtigt die Eingangskapazität als ein kapazitives Element, das parallel zum Reihenschwingkreis geschaltet ist. Die das Verhalten des Serienschwingkreises beschreibenden Strom- und Spannungsgrößen sind wegen der parallelen Eingangskapazität nicht direkt zugänglich.

Der erste Schaltungszweig weist eine Reihenschaltung des Piezotransformators und eines ersten Widerstands auf. Der zweite Schaltungszweig weist eine Reihenschaltung eines kapazitiven Elements und eines zweiten Widerstands auf. Der zweite Schaltungszweig ist in gleicher Weise aufgebaut wie die Serienschaltung von Eingangskapazität und erstem Widerstand.

Eine Serienschaltung von Kapazität und Widerstand ist ein Hochpass. Die Symmetrie der Hochpässe im ersten und zweiten Schaltungszweig erlaubt die Kompensation der Eingangskapazität, indem die Zeitkonstante der Reihenschaltung von kapazitivem Element und zweitem Widerstand des ersten Schaltungszweiges gleich oder nahezu gleich der Zeitkonstante der Reihenschaltung von Eingangskapazität und erstem Widerstand des zweiten Schaltungszweiges ist.

Der Piezotransformator ist zwischen einem ersten und einem zweiten Potenzialpunkt im ersten Schaltungszweig, und der erste Widerstand ist zwischen dem zweiten und einem dritten Potenzialpunkt im ersten Schaltungszweig. Das kapazitive Element ist zwischen einem ersten und einem zweiten Potenzialpunkt im zweiten Schaltungszweig, und der zweite Widerstand ist zwischen dem zweiten und einem dritten Potenzialpunkt im zweiten Schaltungszweig. Der zweite Potenzialpunkt ist im ersten Schaltungszweig mit dem ersten Eingang gekoppelt, und der zweite Potenzialpunkt im zweiten Schaltungszweig ist mit dem zweiten Eingang gekoppelt.

Wegen der gleichen Zeitkonstanten treten die Signale in den Hochpässen mit den gleichen Amplituden und Phasenlagen auf, unabhängig von Frequenz und Amplitude der Ansteuerung. Gemeinsam betrachtet treten beide Signale als Gleichtaktspannungen am Eingang des Differenzverstärkers auf, sodass sie vom Differenzverstärker und damit der Signalanteil der Eingangskapazität des Piezotransformators herausgefiltert werden.

Das derart gewonnene Signal wird in einer Schleife zurückgekoppelt und ist Grundlage der Piezotransformatoransteuerung. Zu diesem Zweck ist ein Ausgang des Differenzverstärkers über einen Rückkoppelzweig mit dem Piezotransformator gekoppelt. Vorteilhafterweise liegt das rückgekoppelte Signal an den ersten Potenzialpunkten des ersten und zweiten Schaltungszweiges und damit der Eingangselektrode des Piezotransformators an. Die dritten Potenzialpunkte liegen auf einem Referenzpotenzial, was auch als Masse bezeichnet wird, sodass eine Parallelschaltung der Hochpässe vorliegt.

In einer Ausgestaltung ist im Rückkoppelzweig ein weiterer Verstärker vorgesehen, der die Ansteuerspannung für den Piezotransformator bereitstellen kann. Im Rückkoppelzweig kann ein Amplitudenregler vorgesehen sein, der dem weiteren Verstärker vorangestellt ist.

In einer Ausgestaltung ist der Ausgang des Differenzverstärkers über einen Pulsweitenmodulator und zwei zwischen zwei Potenzialpunkten in Serie geschalteten Schalterelementen mit dem Piezotransformator gekoppelt. Die Schalterelemente werden durch das Pulsweitensignal angesteuert, indem in Abhängigkeit vom Pulsweitensignal einer der Schalter leitend mit dem benachbarten Referenzpotenzial verbunden ist. Zwischen den Schalterelementen wird die Ansteuerspannung für den Piezotransformator abgegriffen. Diese Anordnung verstärkt das rechteckförmige Pulsweitensignal.

Vorteilhafterweise weist die Schaltungsanordnung eine Spannungsregelungsschleife, bei der ein am Ausgang des Differenzverstärkers anliegendes Signal zurückgeführt wird, und eine Stromregelungsschleife, bei der ein Strom durch den Piezotransformator zurückgeführt wird, auf, sodass der detektierte Strom und Spannung bei der Ansteuerung berücksichtigt wird. Die zurückgeführten Signale werden mit einem Sollsignal verglichen. In Abhängigkeit des Vergleichs wird die Ansteuerung des Piezotransformators verändert.

Das korrespondierende Verfahren zur Ansteuerung eines Piezotransformators, der eine Eingangskapazität hat, in einem ersten Schaltungszweig, umfasst die Spannungsdifferenz zwischen dem ersten Schaltungszweig und einem zweiten Schaltungszweig, der die Eingangskapazität kompensiert, zu erfassen und in einer Rückkopplungsschleife zum Piezotransformator zurückzukoppeln. In dieser Schleife können natürlich weitere Komponenten vorgesehen sein.

Der erste Schaltungszweig weist bei diesem Verfahren eine Reihenschaltung des Piezotransformators und eines ersten Widerstands, zwischen denen das Potenzial abgegriffen wird, und der zweite Schaltungszweig eine Reihenschaltung eines kapazitiven Elements und eines zweiten Widerstands auf, zwischen denen das Potenzial abgegriffen wird. Dabei ist die Zeitkonstante der Reihenschaltung von kapazitivem Element und zweitem Widerstand des zweiten Schaltungszweiges gleich oder nahezu gleich der Zeitkonstante der Reihenschaltung von Eingangskapazität und erstem Widerstand des ersten Schaltungszweiges.

Nachfolgend wird die Erfindung unter Bezugnahme auf die Zeichnung anhand von Ausführungsbeispielen erklärt.

Es zeigen:
- Figur 1: schematisch eine Ansteuerschaltung für einen Piezotransformator,
- Figur 2: das Schaltbild einer Schaltungsanordnung zur Ansteuerung eines Piezotransformators,
- Figur 3: eine Beschaltung eines Differenzverstärkers,
- Figur 4: das Schaltbild einer weiteren Schaltungsanordnung zur Ansteuerung eines Piezotransformators, und
- Figur 5: das Schaltbild noch einer weiteren Schaltungsanordnung zur Ansteuerung eines Piezotransformators.

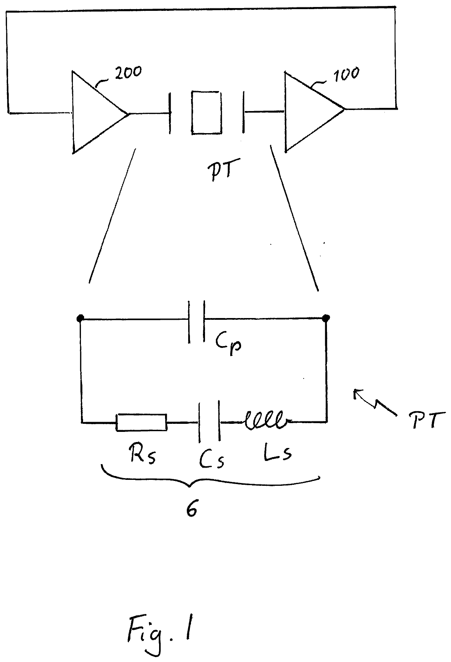

Figur 1 zeigt schematisch eine Ansteuerschaltung für einen Piezotransformator PT. Folgende Ausführungen verdeutlichen zunächst grundsätzliche Überlegungen zur Ansteuerung des Piezotransformators PT in der Ansteuerschaltung, bei der zwei Verstärker 100, 200 in einer Schleife verbunden sind und der Piezotransformator PT als Serienelement eingesetzt ist.

Das Verhalten eines durch eine solche Schaltungsanordnung angesteuerten Piezotransformators PT kann durch ein vereinfachtes Ersatzschaltbild (ESB) beschrieben werden, das die geometrischen Abmessungen des Piezotransformators PT und die dielektrischen, elastischen und piezoelektrischen Materialkonstanten berücksichtigt. Die Komponenten des Ersatzschaltbildes können beispielsweise im Rahmen einer Impedanzmessung bestimmt werden.

Das Ersatzschaltbild umfasst einen verlustbehafteten Serienschwingkreis 6 mit einem kapazitiven Element Cs, einem induktiven Element Ls und einem Widerstand Rs. Parallel zum Serienschwingkreis 6 ist ein kapazitives Element Cp geschaltet, das der Eingangskapazität des Piezotransformators PT entspricht. Die Eingangskapazität Cp ist eine konstruktionsbedingte parasitäre Kapazität, die eine signifikante Wirkung auf den (äußeren) Gesamtstrom hat.

Die Erregung eines Piezotransformators PT auf seiner Resonanzfrequenz kann mittels des selbstschwingenden, rückgekoppelten linearen Verstärkers 100 erfolgen. Zur Erregung auf der Serienresonanzfrequenz oder Parallelresonanzfrequenz wird der Piezotransformator PT vom linearen Verstärker 200 mit geringem Ausgangswiderstand angesteuert. Im Resonanzfall tritt eine Stromüberhöhung am Piezotransformator PT auf. Der Strom durch den Piezotransformator PT kann über einen als Stromshunt dienenden Widerstand (in Figur 1 nicht gezeigt) als Spannung abgebildet und so dem Eingang des Erregerverstärkers zugeführt werden.

Die Phasenbedingung für eine Erregung auf der Resonanzfrequenz ist damit erfüllt, wenn auch mit Einschränkungen auf Grund des Einflusses der

Eingangskapazität Cp. Die Amplitudenbedingung erfordert einen Verstärkungsfaktor, welcher in der Praxis etwas größer sein soll als für die Kompensation der Verluste im Piezotransformator PT erforderlich ist. Eine solche Erregerschaltung mit zwei Verstärkern wird in der Literatur als "Butler"-Schaltung bezeichnet.

Wegen der Eingangskapazität Cp ist der für die Rückkopplung benötigte Strom durch den Serienschwingkreis 6 für eine direkte Erfassung nicht zugänglich. Um dennoch ein für die Erregerschaltung passendes Rückkopplungssignal zu erzeugen, ist eine Schaltung zur Kompensation des Einflusses der Eingangskapazität Cp erforderlich.

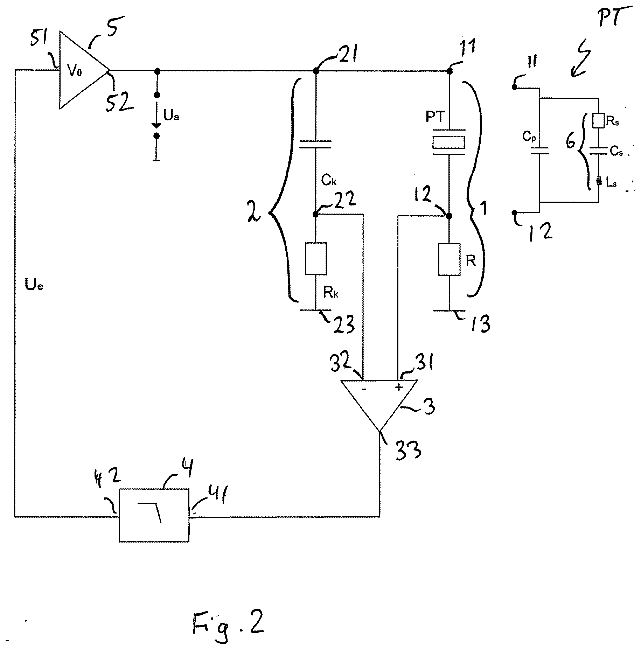

Figur 2 zeigt das Schaltbild einer erfindungsgemäßen Schaltungsanordnung zur Ansteuerung eines Piezotransformators PT, die eine solche Kompensation aufweist.

Die Schaltungsanordnung weist einen ersten Schaltungszweig 1 mit einer Reihenschaltung vom Piezotransformator PT und einem ersten Widerstand R auf sowie einen zweiten Schaltungszweig 2 mit einer Reihenschaltung von einem kapazitiven Element Ck und einem zweiten Widerstand Rk. Der zweite Schaltungszweig 2 dient zur Kompensation des Einflusses der Eingangskapazität Cp des Piezotransformators PT.

Der Piezotransformator PT ist zwischen einem ersten und einem zweiten Potenzialpunkt 11, 12 im ersten Schaltungszweig 1, und der erste Widerstand R ist zwischen dem zweiten und einem dritten Potenzialpunkt 12, 13 im ersten Schaltungszweig 1. Der dritte Potenzialpunkt 13 liegt auf einem Referenzpotenzial, das auch als Masse bezeichnet werden kann. Das kapazitive Element Ck ist zwischen einem ersten und einem zweiten Potenzialpunkt 21, 22 im zweiten Schaltungszweig 2, und der zweite Widerstand Ck ist zwischen dem zweiten und einem dritten Potenzialpunkt 22, 23 im zweiten Schaltungszweig 2. Der dritte Potenzialpunkt 23 liegt auf dem Referenzpotenzial. Der erste und zweite Schaltungszweig 1, 2 sind parallel geschaltet.

Die Schaltungsanordnung weist ferner einen Differenzverstärker 3 mit einem ersten Eingang 31, einem invertierendem zweiten Eingang 32 und einem Ausgang 33 auf. Der erste Eingang 31 ist mit dem zweiten Potenzialpunkt 12 im ersten Zweig 1 verbunden. Der zweite Eingang 32 ist mit dem zweiten Potenzialpunkt 22 im zweiten Zweig 2 verbunden. Alternativ können die Potenzialpunkte 12, 22 auch über weitere Komponenten mit den Eingängen 31, 32 gekoppelt sein. Der Differenzverstärker 3 verstärkt die Differenz der anliegenden Eingangssignale und stellt ausgangsseitig ein entsprechendes Signal bereit. Die Ausgangsspannung hängt bei einem idealen Differenzverstärker mit optimaler Gleichtaktunterdrückung nur noch von der Spannungsdifferenz, nicht aber von der Absoluthöhe der beiden angelegten Spannungen ab.

Die Schaltungsanordnung weist ferner einen Amplitudenregler 4 auf, der die Amplitude des eingangsseitig anliegenden Signals verändert. Falls die Amplitude gemindert wird, spricht man auch von einem Amplitudenbegrenzer. Ausführungsbeispiele des Amplitudenreglers 4 können eine lineare oder nichtlineare Signalbeeinflussung vorsehen. Der Eingang 41 des Amplitudenreglers 4 ist mit dem Ausgang 33 des Differenzverstärkers 3 verbunden.

Die Schaltungsanordnung weist ferner einen weiteren Verstärker 5 auf, der ein eingangsseitiges Signal Ue um den Faktor V0 verstärkt. Ein Eingang 51 des Verstärkers 5 ist mit dem Ausgang 42 des Amplitudenreglers 4 verbunden. Der Ausgang 52 des Verstärkers 5 ist mit den ersten Potenzialpunkten 11, 21 des ersten und zweiten Schaltungszweiges 1, 2 verbunden, sodass eine Ausgangsspannung Ua des Verstärkers 5 sowohl über dem ersten als auch dem zweiten Schaltungszweig 1, 2 anliegt. Alternativ kann der Ausgang 52 des Verstärkers 5 mit den ersten Potenzialpunkten 11, 21 über weitere Komponenten gekoppelt sein.

Die Eingangskapazität Cp und der als Shunt oder Nebenschlusswiderstand dienende erste Widerstand R bilden einen Hochpass, ebenso wie das kapazitive Element Ck und der zweite Widerstand Rk des als Kompensationszweig wirkenden zweiten Schaltungszweigs 2. Die Dimensionierung der Komponenten Ck, Rk, R ist so gewählt, dass beide Hochpasszweige dieselbe Zeitkonstante τ=RC (das heißt τ=R*Cp beziehungsweise τ=Rk*Ck) haben und somit dieselbe Grenzfrequenz. An den Eingängen 31, 32 des Differenzverstärkers 3 treten die Signale sowohl aus dem zweiten Schaltungszweig 2 als auch aus dem Hochpass des ersten Schaltungszweigs 1 mit derselben Amplitude und Phasenlage auf, unabhängig von Frequenz und Amplitude der Ansteuerung. Voraussetzung hierfür ist eine von der Amplitude der anliegenden Spannung unabhängige Eingangskapazität Cp.

Gemeinsam betrachtet treten diese beiden Signale als Gleichtaktspannung eingangsseitig des Differenzverstärkers 3 auf und werden von diesem unterdrückt, sodass nur noch der Signalbetrag des Serienschwingkreises 6 verstärkt wird. Unter idealen Bedingungen liefert der Differenzverstärker 3 ein phasenrichtiges Rückkopplungssignal, das zumindest weitgehend dem Ersatzschaltbild des Piezotransformators PT entspricht.

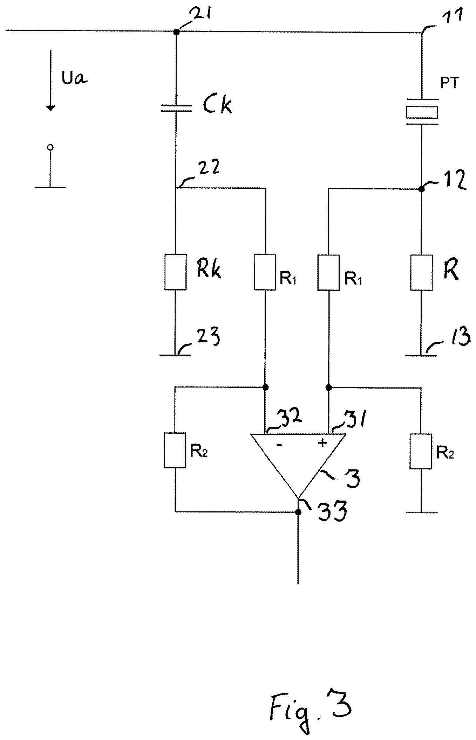

Figur 3 zeigt eine Beschaltung des Differenzverstärkers 3 (Testschaltung), die sich wie folgt von der in Figur 2 dargestellten Beschaltung unterscheidet.

Zwischen dem ersten und zweiten Eingang 31, 32 des Differenzverstärkers 3 und den zweiten Potenzialknoten 12, 22 sind jeweils Widerstände R1 geschaltet. Ferner ist zwischen dem ersten Eingang 31 und dem Referenzpotenzial ein weiterer Widerstand R2 geschaltet. Auch zwischen dem zweiten Eingang 32 und dem Ausgang 33 ist ein weiterer Widerstand R2 geschaltet. Durch die Wahl der Widerstandswerte von R1 und R2 lässt sich der Verstärkungsfaktor einstellen, der von deren Quotienten abhängt. Es sei bemerkt, dass das gezeigte Schaltbild Teil einer Verstärkerschleife sein kann, wie sie in Figur 2 dargestellt ist.

Bei einer solchen Schleife klingt nach Anlegen der Vorsorgungsspannung Ua die Oszillation als Folge des elektrischen Rauschens in der geschlossenen Rückkopplungsschleife an. Vorraussetzung ist, neben der Phasen- und Amplitudenbedingung, ein zumindest bei Kleinsignalen linearer Verstärker mit ausreichender Bandbreite. Der Verstärker soll keine zusätzlichen Phasenverschiebungen verursachen, es sei denn diese sind zum Zweck der Regelung erwünscht. Bei höheren Amplituden kann eine Nichtlinearität im Sinne einer Amplitudenbegrenzung vorhanden und erwünscht sein. Eine Amplitudenbegrenzung ist ebenso am Eingang des Verstärkers möglich. Figur 2 zeigt eine Amplitudenbegrenzung 4 ausgangsseitig des Differenzverstärkers 3.

Das Einfügen eines Amplitudenreglers 4 in den Rückkopplungszweig lässt das Erregersignal sinusförmig bleiben, sodass Oberschwingungen vermieden werden. Eine solche Amplitudenregelung kann über eine Messung der Stromamplitude, einen Vergleich mit einem Sollwert und daraus folgender Änderung des Verstärkungsfaktors der Rückkopplungsschleife erfolgen. Diese Anordnung wird innerhalb der Bandbreite des Verstärkers auf jener Frequenz schwingen, auf der der Piezotransformator PT die höchste Güte, das heißt die höchste Schleifenverstärkung aufweist. Falls dies nicht die gewünschte Arbeitsfrequenz ist, kann in die Rückkopplungsschleife ein Bandpassfilter (nicht dargestellt) eingebaut werden. Damit werden mögliche Nebenresonanzen selektiv unterdrückt.

Das geschilderte Konzept kann in verschiedenen Varianten oder Typen einer Ansteuerungsschaltung eingesetzt werden.

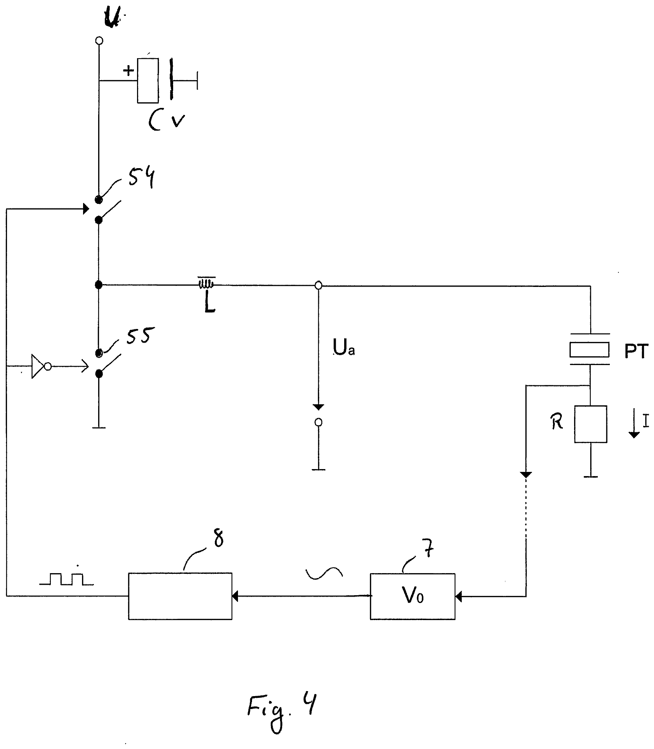

Figur 4 zeigt das schematische Schaltbild einer alternativen Schaltungsanordnung zur Ansteuerung des Piezotransformators, der nicht unter den Schutzbereich der Ansprüche fällt.

Die Schaltungsanordnung weist einen Piezotransformator PT innerhalb einer Messschaltung auf, dessen Strom I über einen Widerstand R fließt. Die zum Strom I über dem Widerstand R proportionale Spannung wird an einen Verstärker 7 angelegt, dessen Ausgang mit einem Pulweitenmodulator 8 gekoppelt ist. Dessen Ausgangssignal ist ein Pulsweitensignal, das heißt ein Rechtecksignal, bei dem der Tastgrad der Rechteckpulse, also die Breite der Rechteckpulse, moduliert wird. Mit dem Pulsweitensignal wird eine Halbbrückenschaltung angesteuert. Bei dieser liegt eine Versorgungsspannung U über zwei in Serie geschalteten Schalterelementen 54, 55, beispielsweise Leistungs-MOSFETs. Das erste Schalterelement 54 ist mit dem Versorgungspotenzial verbunden. Das zweite Schalterelement 55 ist mit dem Referenzpotenzial verbunden. Über ein induktives Element L, das den Ausgangsstrom glättet, liegt die Eingangselektrode des Piezotransformators PT an einem Potenzialpunkt zwischen den Schalterelementen 54, 55 an.

Das Pulsweitensignal steuert eines der Schalterelemente 54 an, und das inverse Pulsweitensignal steuert das andere Schalterelement 55 an, sodass stets eines der Schalterelemente 54, 55 in leitendem Zustand ist, während das andere in nichtleitendem Zustand ist. Wenn das erste Schalterelement 54 in leitendem Zustand ist, liegt die Versorgungsspannung U am Potenzialpunkt zwischen den Schalterelementen 54, 55 an. Wenn das zweite Schalterelement 55 in leitendem Zustand ist, liegt das Referenzpotenzial am Potenzialpunkt zwischen den Schalterelementen 54, 55 an.

Diese Ansteuerung kann wie folgt motiviert sein: Bei Erregung des Piezotransformators PT auf seiner Serienresonanzfrequenz oder Parallelresonanzfrequenz fs fließt der erhöhte Strom auch durch den Leistungsverstärker. Hinzu kommt der Strom durch die parasitäre Eingangskapazität Cp. In einem Verstärker mit Endstufentransistoren im Klasse-AB/B-Betrieb können je nach Baugröße des Piezotransformators PT erhebliche Verlustleistungen auftreten.

Eine mögliche Abhilfe ist der Betrieb der Endstufe in Klasse D (switch-mode). Die Transistoren arbeiten als Schalter 54, 55, ein induktives Element L glättet den Ausgangsstrom.

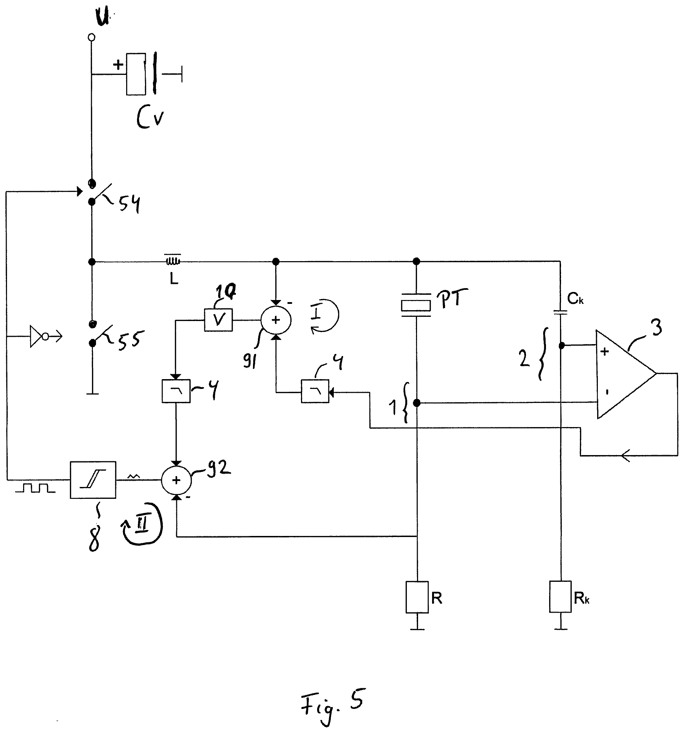

Figur 5 zeigt das schematische Schaltbild einer Schaltungsanordnung mit Eingangkapazitätskompensation basierend auf dem in Figur 4 dargestellten Konzept. Es handelt sich um eine Oszillatorschaltung für einen Piezotransformator mit Klasse-D-Endstufe (switch mode).

Um dem Schaltungskonzept das äußere Verhalten eines linearen Verstärkers zu geben, was erforderlich für das Anschwingen ist, ist ein Pulsweitenmodulator 8 samt Regelung erforderlich.

Hier empfiehlt sich der Betrieb der getakteten Endstufe mit konstanter Stromwelligkeit (Delta I) und innerer Stromregelschleife. Innerhalb dieser Regelschleife kann die Begrenzung des maximalen Ansteuerstroms erfolgen. Damit ist jederzeit eine unbedingte Kurzschlussfestigkeit am Ausgang gegeben.

Eine äußere Spannungsregelschleife stellt den Sollwert des Stroms so ein, dass sich am Ausgang des Verstärkers die gewünschte Spannung Ua ergibt.

Eine derartige Schaltungsanordnung zeigt Figur 5. Die Arbeitsfrequenz der Klasse D-Endstufe soll nennenswert über der Resonanzfrequenz des Piezotransformators PT liegen; ein Faktor 10 oder mehr ist wünschenswert.

Der Kondensator Cv zwischen dem Versorgungs- und Referenzpotenzial dient, in Verbindung mit dem induktiven Element L, als Speicher für den Strom durch den Piezotransformator (Q=CU=it).

Die Schaltungsanordnung weist einen ersten Schaltungszweig 1 mit einer Serienschaltung von einem Piezotransformator PT und einen ersten Widerstand R, der als Shunt dient, auf. Der erste Schaltungszweig 1 ist parallel zu einem zweiten Schaltungszweig 2 mit einer Serienschaltung von einem kapazitiven Element Ck und einem zweiten Widerstand Rk geschaltet. Zwischen den Komponenten PT und R beziehungsweise Ck und Rk der jeweiligen Schaltungszweige 1, 2 wird das Signal abgegriffen und einem Differenzverstärker 3 zugeführt. Ausgangsseitig ist ein Amplitudenregler 4 oder Amplitudenbegrenzer vorgesehen, dessen Ausgangssignal an einem ersten Subtrahierelement 91 anliegt. Am ersten Subtrahierelement 91 liegt ebenfalls die Sollspannung, die nach dem induktiven Element 9 abgegriffen wird, an. Das Substrahierelement 91 stellt ausgangsseitig die Differenz zweier Eingangssignale bereit. Ausgangsseitig ist der Subtrahierer mit einem Regler 10 verbunden, der die Differenz der am Subtrahierer 91 anliegenden Signale verändert, insbesondere verstärkt. Die resultierende Spannung wird über einen Begrenzer 4 als Sollwert an ein zweites Subtrahierelement 92 geführt, an dem auch die Spannung über dem ersten Widerstand R anliegt, die proportional zum Strom durch den Piezotransformator PT ist. Die resultierende Abweichung von Soll- und Istwert ausgangsseitig des Subtrahierelements 92 wird an einen Signalgenerator 8 gekoppelt, der das Pulsmodensignal zur Ansteuerung der Halbbrückenschaltung mit zwei in Serie geschalteten Schalterelementen 54, 55, wie bereits bei Figur 4 beschrieben, generiert.

Diese Schaltungsanordnung weist sowohl eine Rückkopplungsschleife I zur Spannungsregelung auf, bei der die Erregerspannung und die amplitudengeregelte Ausgangsspannung am Differenzverstärker vom ersten Subtrahierelement 91 verglichen werden und das Resultat zum Subtrahierelement 92 geführt wird. Eine zweite Rückkopplungsschleife II zur Stromregelung vergleicht den sich ergebenden Wert, der proportional zum Sollstrom ist, mit der zum Iststrom proportionalen Spannung über dem Shunt R und steuert in Abhängigkeit des Ergebnisses den Piezotransformator PT an.

Das beschriebene Kompensationskonzept kann auch mit einer Ansteuerschaltung anderen Typs kombiniert werden. Es ist lediglich erforderlich, die Variablen des Piezotransformators PT mittels eines Kompensationszweiges 2 und eines Differenzverstärkers 3 zu erfassen und in die Ansteuerung einzuspeisen.

Anstatt eines linearen Verstärkers können auch andere Verstärkertypen verwendet werden, wie z.B. auch eine Auslegung mit einem Schaltregelverstärker.

Es sei noch bemerkt, dass die Merkmale der Ausführungsbeispiele kombinierbar sind. Außerdem kann dieses Konzept auch für andere Piezoprodukte angewandt werden.

### Bezugszeichen

- PT: Piezotransformator
- R, Rk, Rs, R1, R2: Widerstand
- Cp: Eingangskapazität
- Ck, Cs, Cv: kapazitives Element
- L, Ls: induktives Element
- 1, 2: Schaltungszweig
- 3, 5, 7, 100, 200: Verstärker
- 4: Amplitudenregler
- 6: Reihenschwingkreis
- 11, 12, 13, 21, 22, 23: Potenzialpunkt
- 31, 32, 41, 51: Eingang
- 33, 42, 52: Ausgang
- 54, 55: Schalterelement
- 91, 92: Subtrahierelement

## Patentansprüche

1. Schaltungsanordnung umfassend
- einen ersten Schaltungszweig (1) aufweisend eine Reihenschaltung eines Piezotransformators (PT), der eine Umsetzung einer zugeführten elektrischen Wechselspannung in eine höhere oder niedrigere Wechselspannung ermöglicht und der eine Eingangskapazität (Cp) hat, und eines ersten Widerstands (R),
wobei der Piezotransformator (PT) zwischen einem ersten und einem zweiten Potenzialpunkt (11, 12) im ersten Schaltungszweig (1) ist und
der erste Widerstand (R) zwischen dem zweiten und einem dritten Potenzialpunkt (12, 13) im ersten Schaltungszweig (1) ist,
- einen zweiten Schaltungszweig (2), der die Eingangskapazität (Cp) kompensiert und eine Reihenschaltung eines kapazitiven Elements (Ck) und eines zweiten Widerstands (Rk) aufweist,
wobei das kapazitive Element (Ck) zwischen einem ersten und einem zweiten Potenzialpunkt (21, 22) im zweiten Schaltungszweig (2) ist und
der zweite Widerstand (Rk) zwischen dem zweiten und einem dritten Potenzialpunkt (22, 23) im zweiten Schaltungszweig (2) ist,
wobei der erste und zweite Schaltungszweig (1, 2) parallel geschaltet sind und die Zeitkonstante der Reihenschaltung von kapazitivem Element (Ck) und zweitem Widerstand (Rk) des zweiten Schaltungszweiges (2) gleich oder nahezu gleich der Zeitkonstante der Reihenschaltung von Eingangskapazität (Cp) und erstem Widerstand (R) des ersten Schaltungszweiges (1) ist, und
- einen Differenzverstärker (3) mit einem ersten Eingang (31), der gekoppelt ist mit dem ersten Schaltungszweig (1), und einem zweiten Eingang (32), der gekoppelt ist mit dem zweiten Schaltungszweig (2), wobei der zweite Potenzialpunkt (12) im ersten Schaltungszweig (1) mit dem ersten Eingang (31) gekoppelt ist und der zweite Potenzialpunkt (22) im zweiten Schaltungszweig (2) mit dem zweiten Eingang (32) gekoppelt ist und wobei ein Ausgang (33) des Differenzverstärkers (3) über einen Rückkoppelzweig mit dem Piezotransformator (PT) gekoppelt ist.

2. Schaltungsanordnung nach Anspruch 1,
wobei in einem Ersatzschaltbild des Piezotransformators (PT) mit einem Reihenschwingkreis (6), umfassend ein kapazitives Element (Cs), ein induktives Element (Ls) und einem Widerstand (Rs), die Eingangskapazität (Cp) einem kapazitiven Element (Cp), das parallel geschaltet zum Reihenschwingkreis (6) ist, entspricht.

3. Schaltungsanordnung nach Anspruch 1 oder 2,
wobei ein rückgekoppeltes Signal an den ersten (11, 21) Potenzialpunkten des ersten und zweiten Schaltungszweiges (1, 2) anliegt.

4. Schaltungsanordnung nach einem der vorhergehenden Ansprüche,
wobei im Rückkoppelzweig ein weiterer Verstärker (5, 54, 55) ist.

5. Schaltungsanordnung nach einem der vorhergehenden Ansprüche,
wobei im Rückkoppelzweig ein Amplitudenregler (4) ist.

6. Schaltungsanordnung nach einem der vorhergehenden Ansprüche,
wobei der Ausgang (33) des Differenzverstärkers (3) über einen Pulsweitenmodulator (8) und zwei zwischen zwei Potenzialpunkten in Serie geschalteten Schalterelementen (54, 55) mit dem Piezotransformator (PT) gekoppelt ist.

7. Schaltungsanordnung nach einem der vorhergehenden Ansprüche,
aufweisend eine Spannungsreglungsschleife (I), bei der ein am Ausgang (33) des Differenzverstärkers (3) anliegendes Signal zurückgeführt wird, und eine Stromreglungsschleife (II), bei der ein Signal, das proportional zum Strom durch den Piezotransformator (PT) ist, zurückgeführt wird.

8. Verfahren zur Ansteuerung eines Piezotransformators (PT), der eine Umsetzung einer zugeführten elektrischen Wechselspannung in eine höhere oder niedrigere Wechselspannung ermöglicht und der eine Eingangskapazität (Cp) hat, in einem ersten Schaltungszweig (1), wobei das Verfahren umfasst, die Spannungsdifferenz zwischen dem ersten Schaltungszweig (1) und einem zweiten Schaltungszweig (2), der die Eingangskapazität (Cp) kompensiert, zu erfassen und in einer Rückkopplungsschleife zum Piezotransformator (PT) zurückzukoppeln,
wobei der erste Schaltungszweig (1) eine Reihenschaltung des Piezotransformators (PT) und eines ersten Widerstands (R) aufweist, zwischen denen das Potenzial abgegriffen wird, und der zweite Schaltungszweig (2) eine Reihenschaltung eines kapazitiven Elements (Ck) und eines zweiten Widerstands (Rk) aufweist, zwischen denen das Potenzial abgegriffen wird, wobei der erste und zweite Schaltungszweig (1, 2) parallel geschaltet sind
und die Zeitkonstante der Reihenschaltung von kapazitivem Element (Ck) und zweitem Widerstand (Rk) des zweiten Schaltungszweiges (2) gleich oder nahezu gleich der Zeitkonstante der Reihenschaltung von Eingangskapazität (Cp) und erstem Widerstand (R) des ersten Schaltungszweiges (1) ist.

## Claims

1. Circuit assembly comprising
- a first circuit branch (1) comprising a series connection of a piezoelectric transformer (PT), which makes it possible to convert a supplied AC voltage into a higher or lower AC voltage and which has an input capacitance (Cp), and a first resistor (R),
wherein the piezoelectric transformer (PT) is between a first and a second potential point (11, 12) in the first circuit branch (1) and
the first resistor (R) is between the second and a third potential point (12, 13) in the first circuit branch (1),
- a second circuit branch (2) which compensates for the input capacitance (Cp) and comprises a series connection of a capacitive element (Ck) and a second resistor (Rk),
wherein the capacitive element (Ck) is between a first and a second potential point (21, 22) in the second circuit branch (2) and
the second resistor (Rk) is between the second and a third potential point (22, 23) in the second circuit branch (2),
wherein the first and second circuit branches (1, 2) are connected in parallel and the time constant of the series connection of the capacitive element (Ck) and the second resistor (Rk) in the second circuit branch (2) is equal to or nearly equal to the time constant of the series connection of the input capacitance (Cp) and the first resistor (R) in the first circuit branch (1), and
- a differential amplifier (3) having a first input (31) which is coupled to the first circuit branch (1), and a second input (32) which is coupled to the second circuit branch (2), wherein the second potential point (12) in the first circuit branch (1) is coupled to the first input (31), and the second potential point (22) in the second circuit branch (2) is coupled to the second input (32) and wherein an output (33) of the differential amplifier (3) is coupled to the piezoelectric transformer (PT) via a feedback branch.

2. Circuit assembly according to Claim 1,
wherein, in an equivalent circuit diagram of the piezoelectric transformer (PT) including a series resonant circuit (6) comprising a capacitive element (Cs), an inductive element (Ls), and a resistor (Rs), the input capacitance (Cp) corresponds to a capacitive element (Cp) which is connected in parallel with the series resonant circuit (6).

3. Circuit assembly according to Claim 1 or 2,
wherein a fed-back signal is present at the first (11, 21) potential points of the first and second circuit branches (1, 2).

4. Circuit assembly according to one of the preceding claims,
wherein an additional amplifier (5, 54, 55) is in the feedback branch.

5. Circuit assembly according to one of the preceding claims,
wherein an amplitude controller (4) is in the feedback branch.

6. Circuit assembly according to one of the preceding claims,
wherein the output (33) of the differential amplifier (3) is coupled to the piezoelectric transformer (PT) via a pulse width modulator (8) and two switch elements (54, 55) connected in series between two potential points.

7. Circuit assembly according to one of the preceding claims,
comprising a voltage control loop (I) in which a signal which is present at the output (33) of the differential amplifier (3) is fed back, and a current control loop (II) in which a signal which is proportional to the current flowing through the piezoelectric transformer (PT) is fed back.

8. Method for controlling a piezoelectric transformer (PT) which makes it possible to convert a supplied AC voltage into a higher or lower AC voltage and which has an input capacitance (Cp) in a first circuit branch (1),
wherein the method comprises detecting the voltage difference between the first circuit branch (1) and a second circuit branch (2) which compensates for the input capacitance (Cp), and feeding it back to the piezoelectric transformer (PT) in a feedback loop, wherein the first circuit branch (1) comprises a series connection of the piezoelectric transformer (PT) and a first resistor (R), between which the potential is tapped, and the second circuit branch (2) comprises a series connection of a capacitive element (Ck) and a second resistor (Rk), between which the potential is tapped,
wherein the first and second circuit branches (1, 2) are connected in parallel and the time constant of the series connection of the capacitive element (Ck) and the second resistor (Rk) in the second circuit branch (2) is equal to or nearly equal to the time constant of the series connection of the input capacitance (Cp) and the first resistor (R) in the first circuit branch (1).

## Revendications

1. Arrangement de circuit comprenant
- une première branche de circuit (1) possédant un circuit série d'un transformateur piézoélectrique (PT), qui permet une conversion d'une tension alternative électrique acheminée en une tension alternative plus élevée ou plus basse et qui comprend un condensateur d'entrée (Cp), et d'une première résistance (R),
le transformateur piézoélectrique (PT) se trouvant entre un premier et un deuxième point de potentiel (11, 12) dans la première branche de circuit (1) et
la première résistance (R) se trouvant entre le deuxième et un troisième point de potentiel (12, 13) dans la première branche de circuit (1),
- une deuxième branche de circuit (2), qui compense le condensateur d'entrée (Cp) et possède un circuit série d'un élément capacitif (Ck) et d'une deuxième résistance (Rk),
l'élément capacitif (Ck) se trouvant entre un premier et un deuxième point de potentiel (21, 22) dans la deuxième branche de circuit (2) et
la deuxième résistance (Rk) se trouvant entre le deuxième et un troisième point de potentiel (22, 23) dans la deuxième branche de circuit (2),
la première et la deuxième branche de circuit (1, 2) étant branchées en parallèle et la constante de temps du circuit série de l'élément capacitif (Ck) et de la deuxième résistance (Rk) de la deuxième branche de circuit (2) étant égale ou approximativement égale à la constante de temps du circuit série du condensateur d'entrée (Cp) et de la première résistance (R) de la première branche de circuit (1), et
- un amplificateur différentiel (3) pourvu d'une première entrée (31), laquelle est connectée à la première branche de circuit (1), et d'une deuxième entrée (32), laquelle est connectée à la deuxième branche de circuit (2), le deuxième point de potentiel (12) dans la première branche de circuit (1) étant connecté à la première entrée (31) et le deuxième point de potentiel (22) dans la deuxième branche de circuit (2) étant connecté à la deuxième entrée (32), et une sortie (33) de l'amplificateur différentiel (3) étant connectée au transformateur piézoélectrique (PT) par le biais d'une branche de contre-réaction.

2. Arrangement de circuit selon la revendication 1, avec lequel, dans un circuit équivalent du transformateur piézoélectrique (PT) comprenant un circuit oscillant série (6), constitué d'un élément capacitif (Cs), d'un élément inductif (Ls) et d'une résistance (Rs), le condensateur d'entrée (Cp) correspond à un élément capacitif (Cp) qui est branché en parallèle du circuit oscillant série (6).

3. Arrangement de circuit selon la revendication 1 ou 2, un signal envoyé en contre-réaction étant appliqué au niveau des premiers (11, 21) points de potentiel de la première et la deuxième branche de circuit (1, 2).

4. Arrangement de circuit selon l'une des revendications précédentes, un amplificateur supplémentaire (5, 54, 55) se trouvant dans la branche de contre-réaction.

5. Arrangement de circuit selon l'une des revendications précédentes, un régulateur d'amplitude (4) se trouvant dans la branche de contre-réaction.

6. Arrangement de circuit selon l'une des revendications précédentes, la sortie (33) de l'amplificateur différentiel (3) étant connectée au transformateur piézoélectrique (PT) par le biais d'un modulateur de largeur d'impulsion (8) et de deux éléments commutateurs (54, 55) branchés en série entre deux points de potentiel.

7. Arrangement de circuit selon l'une des revendications précédentes, possédant une boucle de régulation de tension (I), avec laquelle un signal présent à la sortie (33) de l'amplificateur différentiel (3) est renvoyé, et une boucle de régulation de courant (II), avec laquelle est renvoyé un signal qui est proportionnel au courant à travers le transformateur piézoélectrique (PT).

8. Procédé d'excitation d'un transformateur piézoélectrique (PT) qui permet une conversion d'une tension alternative électrique acheminée en une tension alternative plus élevée ou plus basse et qui comprend un condensateur d'entrée (Cp), dans une première branche de circuit (1), le procédé comprenant l'acquisition de la différence de tension entre la première branche de circuit (1) et une deuxième branche de circuit (2), qui compense le condensateur d'entrée (Cp), et la réinjection vers le transformateur piézoélectrique (PT) dans une boucle de contre-réaction,
la première branche de circuit (1) possédant un circuit série constitué du transformateur piézoélectrique (PT) et d'une première résistance (R), entre lesquels est prélevé le potentiel, et la deuxième branche de circuit (2) possédant un circuit série constitué d'un élément capacitif (Ck) et d'une deuxième résistance (Rk), entre lesquels est prélevé le potentiel,
la première et la deuxième branche de circuit (1, 2) étant branchées en parallèle et la constante de temps du circuit série constitué de l'élément capacitif (Ck) et de la deuxième résistance (Rk) de la deuxième branche de circuit (2) étant égale ou approximativement égale à la constante de temps du circuit série du condensateur d'entrée (Cp) et de la première résistance (R) de la première branche de circuit (1).
